# EUROPEAN PATENT APPLICATION

(11) **EP 3 223 316 A1**
(43) Date of publication of application: **27.09.2017**
(21) Application number: 16162251.9
(22) Date of filing: 24.03.2016
(51) Int. Cl.: H01L 29/78, H01L 29/165

(54) **WIDE BANDGAP POWER SEMICONDUCTOR DEVICE AND METHOD FOR MANUFACTURING SUCH A DEVICE**

(71) Applicant: ABB Technology AG, 8050 Zürich (CH)
(72) Inventor: Mihaila, Andrei, 5400 Baden (CH); Minamisawa, Renato, 5200 Brugg (CH); Rahimo, Munaf, 5619 Uezwil (CH); Canales, Francisco, 5405 Baden-Dättwil (CH)
(74) Representative: ABB Patent Attorneys

(57) **Abstract**

A wide bandgap power semiconductor device comprises provided having at least one MOS cell (2, 2') between a first main side (10) and a second main side (15), wherein each MOS cell (2, 2') comprises a drift layer (4) of the first conductivity type, two well layers (5, 5') of a second conductivity type and two source layers (6, 6') of the first conductivity type, which are higher doped than the drift layer (4). On the first main side (10) at each MOS cell (2, 2') two gate electrodes (7, 7') are arranged, wherein an area between the two gate electrodes (7, 7') defines a source opening (20, 20'). In the at least one MOS cell (2) at the source opening (20) a hetero-junction layer (8) consisting of a polycrystalline silicon layer is arranged between the two well layers (5, 5'), wherein the hetero-junction layer (8) has a hetero-junction layer depth (80), which is at least as deep as the well layers (5, 5').

## Description

### Technical Field

The invention relates to the field of power electronics and more particularly to a method for manufacturing a semiconductor device and to such a semiconductor device.

### Background Art

A prior art silicon carbide MOSFET comprises a MOS cell between a first main side and a second main side with an n doped drain layer, an n- doped drift layer, a p doped well layer and two n+ doped source layers. On the first main side two planar gate electrodes are arranged, each of which comprises a gate layer and an insulating layer, which insulates the gate layer from the layers of the MOS cell, wherein an area between the two gate electrodes defines a source opening. At the source opening a source electrode, which electrically contacts the well layer and the source layers.

For such prior art MOSFETs, additionally to the MOS channel a free wheeling diode is formed between the p well layer, which acts as an anode layer, the drift layer and the drain layer, which acts as a cathode layer.

Such a free wheeling diode shows a negative temperature behaviour, which means that for higher temperatures, the forward current density significantly increases. This results in difficulties to arrange the diodes in parallel connection.

### Disclosure of Invention

It is an object of the invention to provide a wide bandgap power semiconductor device comprising at least one MOS cell between a first main side and a second main side, wherein each MOS cell comprises a drift layer of the first conductivity type, two well layers of a second conductivity type and two source layers of the first conductivity type, which are higher doped than the drift layer. On the first main side at each MOS cell two gate electrodes are arranged, each of which comprises a gate layer and an insulating layer, which insulates the gate layer from the layers of the MOS cell, wherein an area between the two gate electrodes defines a source opening. On the first main side a source electrode is arranged at the source opening, which electrically contacts the two well layers and the source layers.

In at least one MOS cell on the first main side at the source opening a hetero-junction layer consisting of a polycrystalline silicon layer is arranged between the two well layers, wherein the hetero-junction layer has a hetero-junction layer depth, which is at least as deep as the well layers.

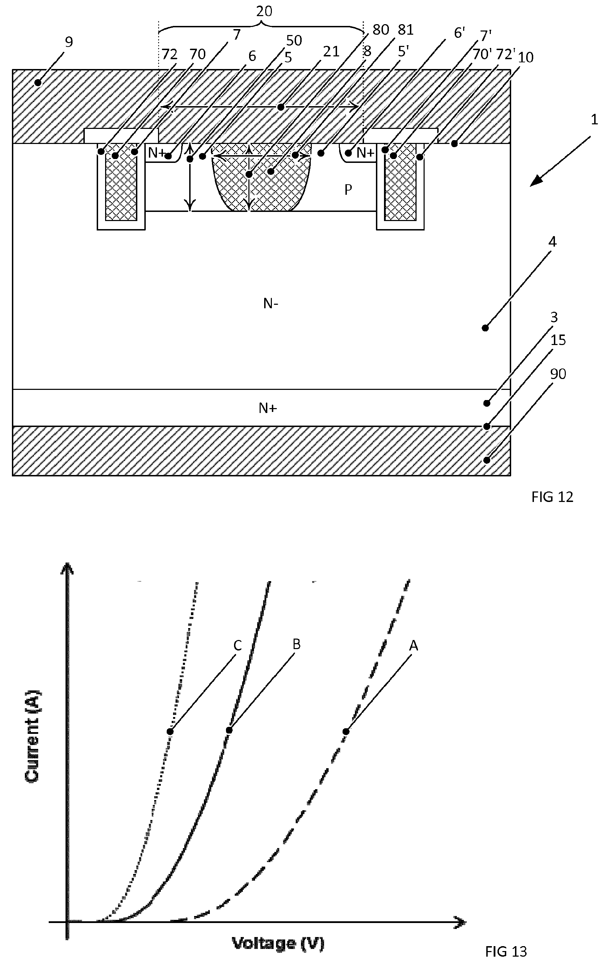

Such a hetero-junction layer integrated into the MOS cell has the advantage that no additional space is needed for the hetero-junction layer as compared to a prior art MOS cell. The layer is arranged in the central part and therefore, in the active area of the MOS cell at a place, at which in prior art MOS cells a highly doped contact layer of the same material as the surrounding source layers, well layers and drift layer are made of. The hetero-junction layer forms the anode layer of a hetero-junction body diode, hetero junction meaning the junction/interface between the wide bandgap material (e.g. silicon carbide) of the source, well and drift layers and the polycrystalline material of the hetero-junction layer. Due to the different energy levels of these materials, the hetero-junction layer may be of the same doping type as the well layer (exemplarily both p type) or of a different/opposite doping type (exemplarily well layer p type, hetero-junction layer n type). As shown in FIG 13, for a p type well layer and a p type heterojunction layer (continuous line marked as "B") the drain voltage can be reduced by a factor of about two compared to a conventional wide bandgap MOS cell (dashed line marked as "A") and with an n type heterojunction layer (dotted line marked as "C") the drain voltage can be further reduced by a factor of about three compared to the prior art devices because of the better band alignment.

Thus, forward voltages can be lowered for even higher current densities, leading to better on-state performance of the hetero-junction body diode. Conduction losses are minimized for the hetero-junction body diode, especially at high temperatures. Also recovery losses can be nearly eliminated with the inventive devices. The introduction of additional pilot hetero-junction body diode cells can further lower the conduction losses.

The hetero-junction body diode offers a positive temperature coefficient (i.e. lower current densities for higher temperatures), which effect is desirable for parallel arranged devices.

Forward bias degration effects which can affect prior art SiC devices in bipolar operation can be elimination as the hetero-junction body diode operates solely in the unipolar mode.

The chip area can be used optimally with the inventive design, as the hetero-junction layer is integrated in the cells. The minimization of space between the cells leads to better input capacitance and consequently also to an improvement for the switching speed of the device. The high cell density and therefore high channel density allows for a better current spreading.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a MOS cell for an inventive power semiconductor device;
- FIG 2: shows an inventive MOSFET having a hetero junction layer with the same depth as the well layers;
- FIG 3: shows an inventive non punch-through IGBT;
- FIG 4: shows an inventive punch-through IGBT;
- FIG 5: shows an inventive reverse-conducting IGBT;
- FIG 6: shows an inventive MOSFET having a hetero junction layer having a greater depth than the well layers;
- FIG 7: shows an inventive MOSFET having a shallow, highly doped protection layer;
- FIG 8: shows an inventive MOSFET having a highly doped protection layer having the same depth as the well layer;
- FIG 9: shows an inventive MOSFET having two MOS cells with hetero-junction layers;
- FIG 10: shows an inventive MOSFET having a separate MOS cell with a wide and deep body diode anode layer;

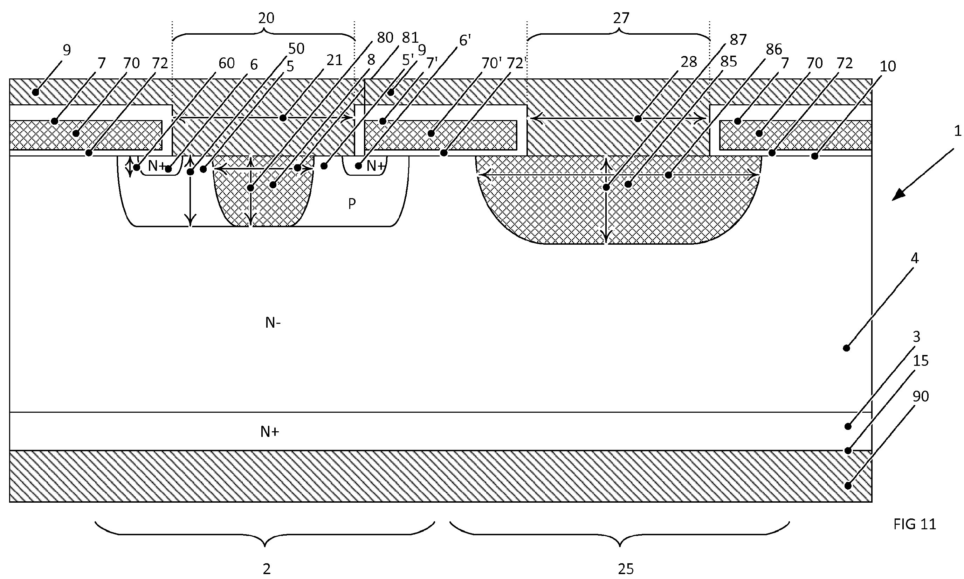

- FIG 11: shows an inventive MOSFET having a separate hetero junction diode cell;
- FIG 12: shows an inventive MOSFET with a trench gate electrode;
- FIG 13: shows the forward current versus forward voltage for inventive devices ("B" and "C") and a prior art device ("A"); and
- FIG 14: shows an inventive MOSFET having a separate MOS cell with a wide and shallow body diode anode layer.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

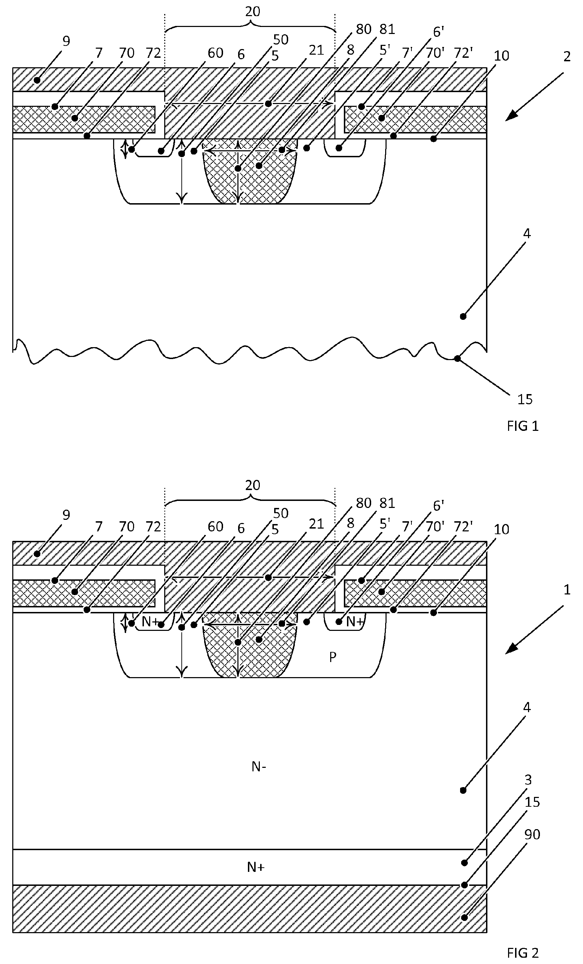

FIG 1 shows a MOS (metal-oxide-semiconductor) cell 2 for an inventive wide bandgap power semiconductor device. Wide band gap materials shall be materials having a bandgap of at least 2 eV like silicon carbide, gallium nitride or diamond or such a group-III-Nitride (AlGaln)N not excluding other wide bandgap materials. Exemplarily, the wide bandgap material is SiC (silicon carbide), exemplarily 3 C, 4 H or 6 H SiC. The layers of the MOS cell 2, 2' shall be a drift layer 4, well layers 5, 5' and source layers 6, 6', all of which layers are made of the wide bandgap material. In such a MOS cell 2, 2', a MOS channel may be formed from the source layers 6, 6' via the well layers 5, 5' to the drift layer 4. Depending on the voltage class, the doping concentration and thickness of the drift layer 4 are chosen. Exemplarily, the drift layer 4 has a doping concentration between 1 * 10¹² and 5*10¹⁷ cm⁻³ and a thickness between 3 to 250 µm. The thicknesses shall be measured in depth direction, i.e. in a direction vertical to the first main side 10.

The MOS cell 2 comprises between a first main side 10 and a second main side 15, a drift layer 4 of the first conductivity type, which is exemplarily of n type, two well layers 5, 5', which are exemplarily of p type, and two n+ doped source layers 6, 6', which are higher doped than the drift layer 4. In this figure, it is indicated by the wiggly line, that the device has further layers on the second main side 15, which will be explained in the figures 2 to 5.

Exemplarily, the source layers 6, 6' may have a depth up to 1 µm. The doping concentration may be at least 1 * 10¹⁹ or between 5* 10¹⁹ and 1 * 10²¹ cm⁻³. The well layers 5, 5' may have a doping concentration between 1 * 10¹⁶ and 5* 10¹⁹ cm⁻³.

On the first main side 10 two planar gate electrodes 7, 7' are arranged at each MOS cell 2. Each gate electrode 7, 7' comprises a gate layer 70, 70' and an insulating layer 72, 72', which insulates the gate layer 70, 70' from the layers of the MOS cell 2. The insulating layer 72, 72' may comprise a first insulating layer and a second insulating layer. The gate layer 70, 70' is separated from any doped layer by the first insulating layer. The source layers 6, 6', the well layers 5, 5' and the drift layer 4 extend to the gate electrode 7, 7', i.e. to the first insulating layer. The gate electrodes 7, 7' are formed in FIG 1 as a planar gate electrodes, wherein the gate electrodes 7, 7' are arranged on top of the source layers 6, 6', the well layers 5, 5' and the drift layer 4 such that a MOS channel may be generated in the well layer 5, 5' below the gate electrode 7 between the source layers 6, 6' and the drift layer 4 by inversion of the well layer by the application of a gate-voltage larger than the threshold-voltage of the MOS interface.

Alternatively to the planar gate electrodes 7, 7', the inventive device may comprise trench gate electrodes 7, 7' (FIG 12), for which trenches have been introduced perpendicular to the first main side 10 laterally to the source layers 6, 6'. In these trenches, an insulating layer covers the walls of the trenches towards the wide band gap layers and separates the gate layer, with which the trenches are filled, from the wide bandgap layers. On the first main side 10, the insulating layer separates the gate layer from the source electrode 9.

In case of the insulating layer 72, 72' being an oxide layer and the gate layer 70, 70' being made of an electrically conductive material, the inversion-channel is called a MOS channel (metal-oxide/insulator-semiconductor), whereas otherwise (insulating layers 72, 72' being made of any insulating materials; e.g. dielectrics such as high-k materials or Silicate glasses such as PSG or BPSG not excluding other insulators) the channel may also be called MIS channel (metal-insulator-semiconductor).

As a material for the gate layer 70, 70' any appropriate electrically conductive material like a metal or doped polycrystalline silicon may be used. The term MOS device/MOSFET shall also cover such MIS devices/ MISFETs and applies also for IGBTs which are MOS/MIS-controlled.

The area between the two gate electrodes 7, 7' in the MOS cell 2 define a source opening 20. A source electrode 9 as an ohmic contact is arranged at the source opening 20 on the first main side 10, which electrically contacts the two well layers 5, 5' and the source layers 6, 6'.

In the area of the source opening 20, a hetero-junction layer 8 is arranged, which consists of a polycrystalline silicon layer. The hetero-junction layer 8 is arranged between the two source layers 6, 6', which contacts the source electrode 9. The hetero-junction layer 8 has a hetero-junction layer depth 80, which is at least as deep as the well layers 5, 5', so that the hetero-junction layer 8 contacts the drift layer 4 on a side opposite to the first main side 10. The hetero-junction layer is arranged between the two well layers 5, 5' and between the two source layers 6, 6'.

Gate layers 70, 70' and hetero-junction layer 8 may be made of the same material, i.e. of polycrystalline silicon.

Such MOS cell 2 may be integrated in an inventive MOSFET 1 (metal-oxide-semiconductor field effect transistor) as shown in FIG 2. For such an inventive MOSFET 1, an n doped drain layer 3 is arranged on the second main side 15, which has a higher doping concentration than the drift layer 4. Exemplarily, the doping concentration is between 1 * 10¹⁹ and 1 * 10²⁰ cm⁻³, exemplarily above 5 * 10¹⁸. The drain layer 3 attaches towards the first main side 10 the drift layer 4 and contacts on the second main side 15 a drain electrode 90 as an ohmic contact.

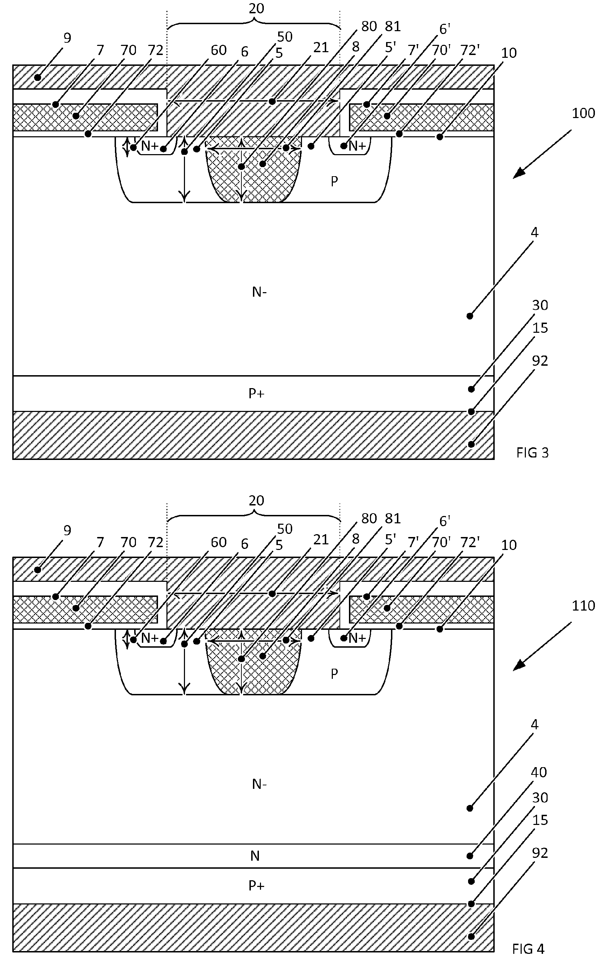

The inventive MOS cell 2 can also be applied to a non punch-through IGBT 100 (insulated gate bipolar transistor), which comprises on the second main side 15 a p doped collector layer 30, which has exemplarily has exemplarily a doping concentration between 1 * 10¹⁸ and 1 * 10²⁰ cm⁻³. The collector layer 3 contacts a collector electrode 92 as an ohmic contact. For a non punch-through IGBT as shown in FIG 3, the collector layer 3 contacts towards the first main side 10 the drift layer 4. In FIG 4, the inventive MOS cell 2 is applied to a punch-through IGBT 110 (i.e. an IGBT with a buffer layer, which additionally comprises between the drift layer 4 and the collector layer 3 an n doped buffer layer 40, which has a higher doping concentration than the drift layer 4. The buffer layer may have an exemplary doping concentration between 1 * 10¹⁷ and 1 * 10¹⁹ cm⁻³ and a thickness up to 3 µm. In case of the non-punch through design the E-field is triangular in shape up to avalanche breakdown. In the other cases the E-field penetrates through the interface between drift layer 4 and buffer layer 40 where it gets stopped due to the high doping concentration of the buffer layer 40.

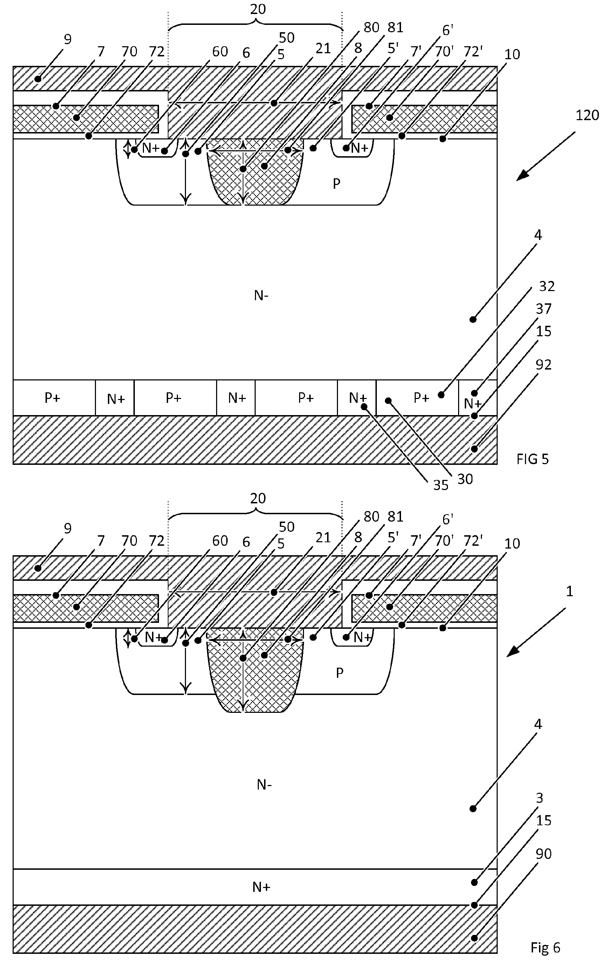

In a further exemplary embodiment, the inventive MOS cell 2 may be applied to a reverse-conducting IGBT 120 (FIG 5), which comprises additionally to the non punch-through IGBT 100 or punch-through IGBT 110 an n doped cathode layer 35, which comprises a plurality of cathode regions 37. The collector layer 3 also comprises a plurality of collector regions 32. The cathode layer 35 is higher doped than the drift layer 4, and, if a buffer layer 40 is arranged between drift and collector layer 4, 3, the cathode layer 35 has also higher doping concentration than the buffer layer 40. Cathode and collector regions 37, 32 are arranged alternatingly on the second main side 15 and contact the collector electrode 92.

Exemplarily, an inventive reverse-conducting IGBT 120 is formed as a Bi-mode Insulated Gate Transistor (BIGT) additionally having a large pilot p+ collector layer in the central part of the device on the second main side 15 surrounded by alternating smaller p+ collector regions 32 and n+ cathode regions. Such BIGTs are disclosed in US 8 212 283 B2, which document shall be incorporated by reference for the design of a BIGT.

All designs are explained and shown in the figures for an inventive MOSFET, but are also applicable to an IGBT (of a non-punch through or punch-through as well as reverse-conducting type.

In an exemplary embodiment, the hetero-junction layer 8 has a doping concentration of at least 5 * 10¹⁹ cm⁻³. The hetero-junction layer 8 may either be of n-doping type or of p-doping type. An n-doping type further minimizes the hetero-junction body diode conduction losses as compared to p-doping type as explained for FIG 13.

In another exemplary embodiment, the well layers 5, 5' have a well layer depth 50 between 0.5 and 3 µm. In the embodiment, shown in FIG 1, the hetero-junction layer 8 has a hetero-junction layer depth 80, which is the same as the well layer depth 50. A depth of a layer shall be the maximum extension of the layer from the first main side 10.

In another exemplary embodiment shown in FIG 6, the hetero-junction layer depth is deeper than the well layer depth 50. Exemplarily, the hetero-junction layer depth is at most 0.5 µm deeper than the well layer depth 50. By having a larger hetero-junction layer depth 80 than well layer depth 50, it is ensured that the hetero-junction layer 8 attaches the drift layer 4 even if during manufacturing variations in the creation of the hetero-junction layer 8 lead to a smaller thickness, thereby spoiling the direct contact between hetero-junction layer 8 and drift layer 4.

A hetero-junction layer width 81 shall correspond to the maximum diameter of a circle that may be laid into the hetero-junction layer 8 in a plane parallel to the first main side 10. For the inventive device, it is the extension of the hetero-junction layer 8 between the two well layers 5, 5'. Accordingly, the source opening width 20 is the maximum diameter of a circle that may be laid into the opening between the two gate electrodes 7, 7' of a MOS cell 2 in a plane parallel to the first main side 10. In an exemplary embodiment, the hetero-junction layer 8 has a hetero-junction layer width 81, which is between 20 and 80 % of a source opening width 21.

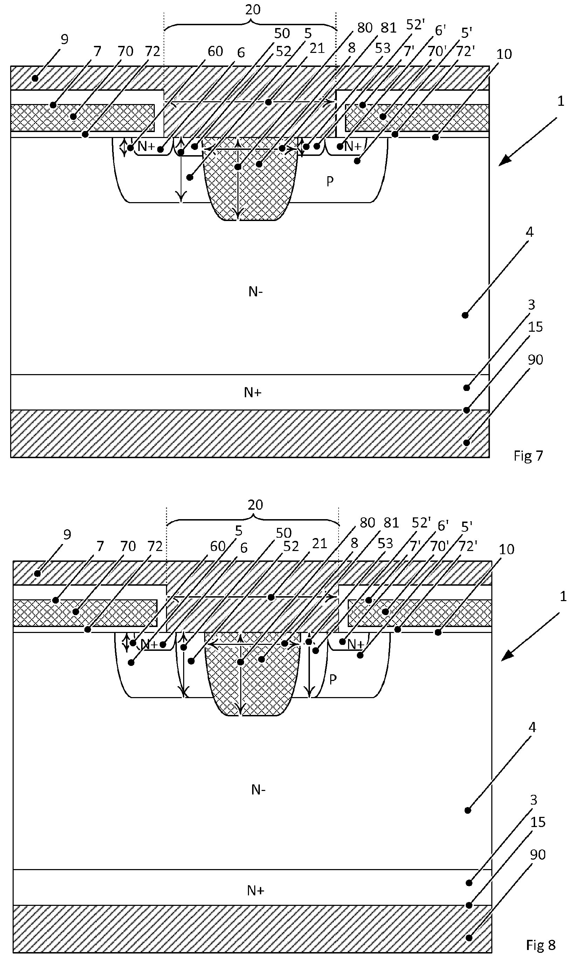

The hetero-junction layer 8 may be surrounded laterally, i.e. in a direction towards the source layers 6, 6' by two p doped protection layers 52, 52' (FIG 7 and 8). Such protection layers 52, 52' are arranged between the hetero-junction layer 8 and the well layers 5, 5' and attach the hetero-junction layer 8. The protection layers 52, 52' are arranged at the first main side 10 at the surface so that they contact the source electrode 9. The protection layers 52, 52' are higher doped than the well layers 5, 5'.

The protection layers 52, 52' may have a protection layer depth 53, which is less than the well layer depth 50 as shown in FIG 7. Alternatively, the protection layers 52, 52' may have a protection layer depth 53, which is the same as the well layer depth 50 (FIG 8). Thereby, the protection layers 52, 52' separate the hetero-junction layer 8 from the well layers 5, 5'.The maximum depth, to which the protection layers 52, 52' may extend, is the depth of the hetero-junction layer 8 to ensure the contact between the hetero-junction layer 8 and the drift layer 4. Such a protection layer 52, 52' as shown in FIG 8 further improves the body diode operation behaviour as bipolar operation functionality is added.

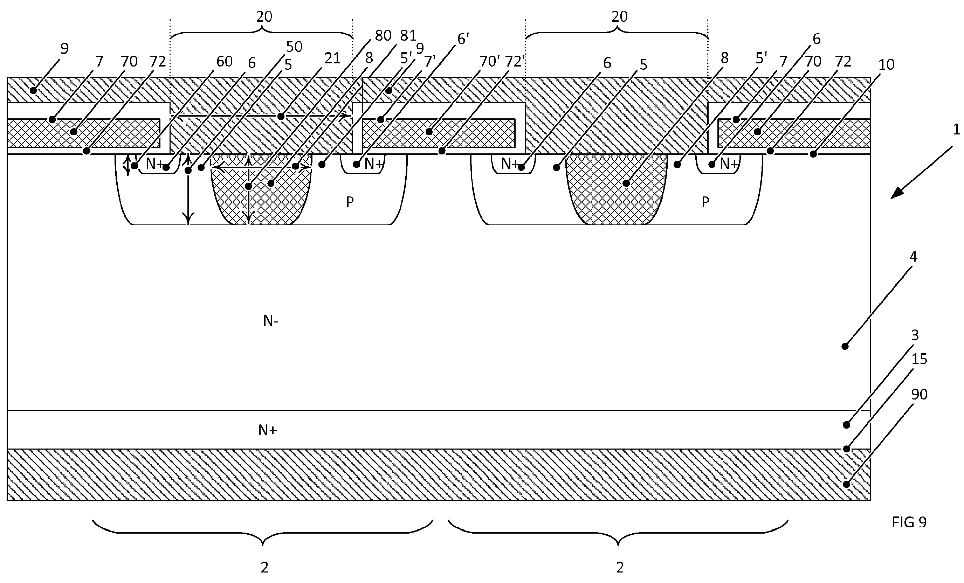

The power semiconductor device may comprise just one MOS cell as shown in FIG 2, but the power device may also comprise a plurality, i.e. two or more of such inventive MOS cells 2. Such cells 2 may be arranged receptively to the lateral sides of the MOS cell 2, i.e. at the gate electrode 7 and 7' may be continued to form also a gate electrode 7, 7' of a neighboured MOS cell 2. FIG 9 shows an example of a device with two such MOS cells 2. The right gate layer 7' of the left handed cell 2 forms a continuous gate layer with the left gate layer of the right handed cell. The same applies to the insulating layer, so that the two gate electrodes 7, 7' of neighboured cells facing each other form a common gate electrode. The cells 2, i.e. the regions in the cells, may be designed to form of regular patterns like stripes, hexagonal, triangular or square design. Such MOS cells may be interconnected to each other.

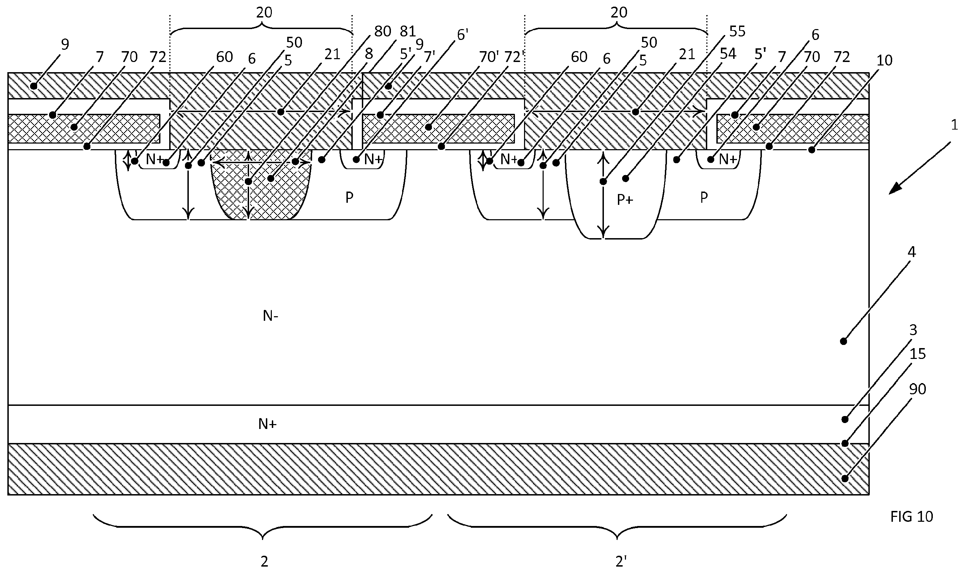

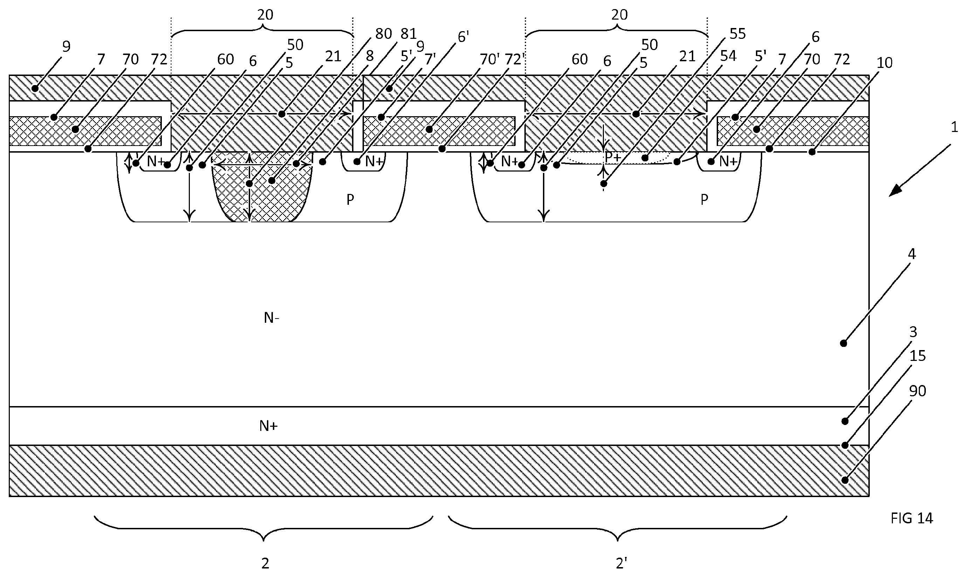

In another inventive embodiment, the inventive MOSFET comprises an inventive MOS cell 2 as disclosed above and additionally, the device comprises a MOS cell 2', which is a further MOS cell, with source layers 6, 6', well layers 5, 5' and drift layer 4 (FIG 10 and 14). At the source opening 20' of such MOS cell 2' (i.e. on the first main side 10), a p+ doped body diode anode layer 54 is arranged, which has a higher doping concentration than the well layers 5, 5'. The body diode anode layer 54 is made of the same wide bandgap material as the layers of the MOS cell 2', i.e. of the source layers 6, 6', well layers 5, 5' and drift layer 4. The body diode anode layer 54 may be a shallow (but highly doped) contact layer, which has a lower depth than the well layers 5, 5' to establish a good ohmic contact to the source electrode 9 (FIG 14). The body diode anode layer 54 may be arranged only in the central part of the source opening 20 with a contact to the well layers 5,5' laterally from the body diode anode layer 54 (dotted line). For an even better ohmic contact, in such a further MOS cell 2' the contact from the source electrode 9 to a p doped layer is only formed at the body diode anode layer 54, i.e. the body diode anode layer 54 extends to the source layers 6, 6'.

In another embodiment, the body diode anode layer 54 extends to a body diode anode layer depth 55, which is at least as deep as or deeper than the well layer depth 50 (FIG 10).

Such a pure SiC MOS cell 2' adds a region, which can be operated in bipolar mode. In an exemplary embodiment, the MOS cells 2 alternate with the further MOS cells 2' at a ratio of 1 : 1 to 20 : 1 (i.e. up to 20 MOS cells 2 alternating with one further MOS cell 2'). Alternating MOS cell 2 with a further MOS cell 2' may mean that the MOS cells 2,2' share a common gate electrode 7, 7', i.e. the gate electrode 7 of the MOS cell 2 may be continued to form also a gate electrode 7' of a neighboured MOS cell 2' similar to the situation explained for FIG 9. The MOS cells 2 and further MOS cells 2' could also be arranged in rows, i.e. in one row all common gate electrodes 7, 7' are shared between MOS cells 2 and in another row all common gate electrodes 7, 7' are shared between further MOS cells 2'. Any combination of the above mentioned arrangements or other arrangements of MOS cells 2 and further MOS cells 2' is possible.

In another inventive embodiment, the inventive MOSFET 1 comprises a hetero-junction body diode cell 25 (i.e. one or more) with the following layers: the drift layer 4 and a pilot hetero-junction layer 85, which electrically contacts the source electrode 9. The at least one hetero-junction body diode cell 25 is neighboured by two MOS cells 2 on its lateral sides. The planar gate electrodes 7, 7' on top of the neighbouring MOS cells 2 define a pilot opening 27. At the pilot opening 27, the source electrode 9 contacts the pilot hetero-junction layer 85. The pure hetero-junction body diode cell 25 improves the conduction losses.

The inventive device may also comprise a hetero-junction body diode cell 25, which is neighboured by one MOS cell 2 on one lateral side and to an insulating layer on the opposite lateral side of the body diode cell 25 (the insulating layer could also be the insulating layer 72' of a gate electrodes 7' of another neighbouring MOS cell 2 as described above). In this case, the gate electrode 7, 7' of the neighboured MOS cell 2, 2' and the insulating layer define a pilot opening 27. At the pilot opening 27, the source electrode 9 only contacts the pilot hetero-junction layer 85.

At the pilot opening, there is no other layer connected to the source electrode 9. The pilot hetero-junction layer 85 is made of the same material as the hetero-junction layer 8 (i.e. of polycrystalline silicon). The pilot hetero-junction layer 85 may have a pilot hetero-junction layer width 86 between 3 and 30 µm, wherein the pilot hetero-junction layer width 86 shall be the maximum diameter of a circle, which may be laid into the pilot hetero-junction layer 85 in a plane parallel to the first main side 10.

The values for the doping concentration given above shall be understood as the mean doping concentration for the exemplarily constant doping concentration of the layers (not excluding variation of doping concentration due to imperfection of the manufacturing method).

In another embodiment, the conductivity types of the layers are switched, i.e. all layers of the first conductivity type are p type (e.g. the drift layer 4 and the source layers 6, 6') and all layers of the second conductivity type are n type (e.g. well layer 5, 5').

### List of reference signs

- 1: wide bandgap MOSFET
- 100: wide bandgap non-punch-though IGBT
- 110: wide bandgap punch-though IGBT
- 120: wide bandgap reverse-conducting IGBT
- 10: first main side
- 15: second main side
- 2, 2': MOS cell
- 20, 20': source opening
- 21: source opening width
- 25: hetero-junction body diode cell
- 27: pilot opening
- 28: pilot opening width
- 3: drain layer
- 30: collector layer
- 32: collector region
- 35: cathode layer
- 37: cathode region
- 4: drift layer
- 40: buffer layer
- 5, 5': well layer
- 50: well layer depth
- 52, 52': protection layer
- 53: protection layer depth
- 54: body diode anode layer
- 55: body diode anode layer depth
- 6, 6': source layer
- 60: source layer depth
- 7, 7': gate electrode
- 70, 70': gate layer
- 72, 72': insulating layer
- 8: hetero-junction layer
- 80: hetero-junction layer depth
- 81: hetero-junction layer width
- 85: pilot hetero-junction layer
- 86: pilot hetero-junction layer width
- 87: pilot hetero-junction layer depth
- 9: source electrode
- 90: drain electrode
- 92: collector electrode

## Claims

1. A wide bandgap power semiconductor device comprising at least one MOS cell (2, 2') between a first main side (10) and a second main side (15), wherein each MOS cell (2, 2') comprises a drift layer (4) of the first conductivity type, two well layers (5, 5') of a second conductivity type and two source layers (6, 6') of the first conductivity type, which are higher doped than the drift layer (4),
wherein on the first main side (10) at each MOS cell (2, 2') two gate electrodes (7, 7') are arranged, each of which comprises a gate layer (70, 70') and an insulating layer (72, 72'), which insulates the gate layer (70, 70') from the layers of the MOS cell (2, 2'), wherein an area between the two gate electrodes (7, 7') defines a source opening (20, 20'),
wherein a source electrode (9) is arranged at the source opening (20, 20'), which electrically contacts the two well layers (5, 5') and the source layers (6, 6'), **characterized in, that**
in at least one MOS cell (2) on the first main side (10) at the source opening (20) a hetero-junction layer (8) consisting of a polycrystalline silicon layer is arranged between the two well layers (5, 5'), wherein the hetero-junction layer (8) has a hetero-junction layer depth (80), which is at least as deep as the well layers (5, 5').

2. The wide bandgap power semiconductor device according to claim 1, **characterized in, that** the hetero-junction layer (8) has a doping concentration of at least 5* 10¹⁹ cm⁻³.

3. The wide bandgap power semiconductor device according to any of the claims 1 or 2, **characterized in, that** the well layers (5, 5') have a well layer depth (50) between 0.5 and 3 µm.

4. The wide bandgap power semiconductor device according to any of the claims 1 to 3, **characterized in, that** the hetero-junction layer depth (80) is at most 0.5 µm deeper than a well layer depth (50).

5. The wide bandgap power semiconductor device according to any of the claims 1 to 4, **characterized in, that** the hetero-junction layer (8) has a hetero-junction layer width (81), which is between 20 and 80 % of a source opening width (21).

6. The wide bandgap power semiconductor device according to any of the claims 1 to 5, **characterized in, that** the hetero-junction layer (8) is of the same or a different doping type as the well layers (5, 5').

7. The wide bandgap power semiconductor device according to any of the claims 1 to 6, **characterized in, that** between the hetero-junction layer (8) and each well layer (5, 5') a protection layer (52, 52') of the second conductivity type, which is higher doped than the well layer (5, 5'), is arranged.

8. The wide bandgap power semiconductor device according to claim 7, **characterized in, that** the protection layers (52, 52') extend to a protection layer depth (53), which is less than the well layer depth (50) or **in, that** the protection layers (52, 52') extend to a protection layer depth (53), which is at least as deep as a well layer depth (50).

9. The wide bandgap power semiconductor device according to any of the claims 1 to 8, **characterized in, that** the wide bandgap power semiconductor device comprises at least one MOS cell (2'), which is a further MOS cell, in which on the first main side (10) at the source opening (20') a body diode anode layer (54) of the second conductivity type is arranged having a higher doping concentration than the well layers (5, 5'), which body diode anode layer (54) contacts the source electrode (9).

10. The wide bandgap power semiconductor device according to claim 1, **characterized in, that** the device comprises a plurality of MOS cells (2) and a plurality of further MOS cells (2'), wherein the MOS cells (2) alternate with the further MOS cells (2') with a ratio of 1 : 1 to 20 : 1.

11. The wide bandgap power semiconductor device according to any of the claims 1 to 10, **characterized in, that** the wide bandgap power semiconductor device comprises at least one hetero-junction body diode cell (25) with the following layers:
the drift layer (4) and a pilot hetero-junction layer (85), which electrically contacts the source electrode (9),
wherein the at least one hetero-junction body diode cell (25) is neighboured to a MOS cell (2) and an insulating layer, wherein the gate electrode (7, 7') of the neighboured MOS cell (2, 2') and the insulating layer define a pilot opening (27),
and wherein at the pilot opening (27), the source electrode (9) only contacts the pilot hetero-junction layer (85).

12. The wide bandgap power semiconductor device according to any of the claims 1 to 11, **characterized in, that** the gate layers (70, 70') are made of the same material as the hetero-junction layer (8).

13. The wide bandgap power semiconductor device according to any of the claims 1 to 12, **characterized in, that** the drift layer (4), the well layers (5, 5') and the source layers (6, 6') are made of silicon carbide.

14. The wide bandgap power semiconductor device according to any of the claims 1 to 13, **characterized in, that** the power semiconductor device comprises on the second main side (15) a drain layer (3) of the first conductivity type, which is higher doped than the drift layer (4), wherein on the second main side (15) a drain electrode (90) is arranged, which electrically contacts the drain layer (3).

15. The wide bandgap power semiconductor device according to any of the claims 1 to 13, **characterized in, that** the power semiconductor device comprises on the second main side (15) a collector layer (3) of the second conductivity type, which is higher doped than the drift layer (4), wherein on the second main side (15) a collector electrode (92) is arranged, which electrically contacts the collector layer (3), or, **in that**
the power semiconductor device comprises on the second main side (15) a collector layer (3) of the second conductivity type having a plurality of collector regions (32), wherein the collector layer (3) is higher doped than the drift layer (4), and a cathode layer (35) of the first conductivity type having a plurality of cathode regions (37), wherein the cathode layer (35) is higher doped than the drift layer (4), wherein on the second main side (15) a collector electrode (92) is arranged, which electrically contacts the collector regions (32) and the cathode regions (37), wherein the cathode regions (37) and collector regions (32) are arranged alternatingly.
